Europäisches Patentamt

European Patent Office

Office européen des brevets

(11) Veröffentlichungsnummer: **0 311 976 B1**

## (12) EUROPÄISCHE PATENTSCHRIFT

(45) Veröffentlichungstag der Patentschrift: **02.12.92**

(21) Anmeldenummer: **88116850.4**

(22) Anmeldetag: **11.10.88**

(51) Int. Cl.⁵: **H01J 37/30**

(54) Verfahren und Vorrichtung zur Bestrahlung grosser Flächen mit Ionen.

(30) Priorität: **12.10.87 DE 3734442**

(43) Veröffentlichungstag der Anmeldung:
**19.04.89 Patentblatt 89/16**

(45) Bekanntmachung des Hinweises auf die
Patenterteilung:
**02.12.92 Patentblatt 92/49**

(84) Benannte Vertragsstaaten:
**CH FR GB LI**

(56) Entgegenhaltungen:
**EP-A- 0 104 818**
**WO-A-84/03943**
**FR-A- 2 193 300**
**US-A- 2 866 902**
**US-A- 4 002 912**

**REVIEW OF SCIENTIFIC INSTRUMENTS, Band
58, Nr. 8, August 1987, Seiten 1353-1361,
American Institute of Physics, New York, US;
J.H.M. BONNIE et al.: "Resonance-enhanced
multiphoton ionization for diagnosis of a
weakly ionized plasma"**

(73) Patentinhaber: **Forschungszentrum Jülich
GmbH
Postfach 1913
W-5170 Jülich(DE)**

(72) Erfinder: **Schelten, Jakob, Dr.
Peter-Stommen-Strasse 10
W-5170 Jülich(DE)**

## Beschreibung

Die Erfindung bezieht sich auf ein Verfahren zur Bestrahlung großer Flächen mit Ionen, bei dem die aus einer Ionenquelle austretenden Ionen mittels eines nachgeschalteten Extraktionssystems beschleunigt, mittels eines magnetischen Dipols nach Ionenmassen getrennt, in einer nachgeschalteten Einrichtung nachbeschleunigt werden und der Ionenstrahl sodann fokussiert und auf die um die Mittelachse der Beschleunigungseinrichtungen rotierende, zu bestrahlende Fläche gerichtet wird, und bei dem der Ionenstrahl durch Fokussierung derart aufgeweitet wird, daß die zu bestrahlende Fläche von den hinter dem Fokus auseinanderlaufenden Ionen ganz erfaßt wird. Die Erfindung bezieht sich ferner auf eine Vorrichtung zur Durchführung des Verfahrens.

Ein Verfahren der eingangs bezeichneten Art ist aus der EP-A-0 104 818 bekannt. Bei diesem bekannten Verfahren ist der Ionenstrahl derart aufgeweitet, daß die hinter dem Linsensystem auseinanderlaufenden Ionen die zu bestrahlende Fläche ganz erfassen, was nur durch entsprechende Fokussierung erreicht werden kann. Durch den aufgeweiteten Ionenstrahl wird die zu bestrahlende Fläche zwar ganz erfaßt, jedoch kann hierdurch eine homogene Bestrahlung der Fläche nicht erreicht werden.

In der US-A-4 002 912 ist eine Vorrichtung für eine Bestrahlungseinrichtung beschrieben, bei der Randstrahlen eines Ionenstrahls zum Inneren des Ionenstrahls hin umgelenkt werden, um eine gleichmäßige Bestrahlungsdichte zu erreichen. Eine Verbesserung der Homogenität wird dabei jedoch nur für gaußförmige oder gaußähnliche Strahlprofile erzielt.

Auch ist eine Verfahrensweise bekannt, bei der durch entsprechend seitliche Bewegung der zu bestrahlenden, rotierenden Fläche erreicht wird, daß der in jeweils einem Punkt auf die Fläche auftretende Ionenstrahl die gesamte Fläche bestreicht. Die Stromdichte des Strahls wird dabei konstant gehalten.

Von Nachteil ist dabei, daß durch die konstante Dosis des Strahls Temperaturspitzen auf der zu bestrahlenden Fläche auftreten können, die zu Diffusion und inneren Spannungen führen. Dies kann nur durch eine relativ niedrige mittlere Arbeitstemperatur, d.h. durch eine Begrenzung der Stromdichten nach oben vermieden werden.

Es ist Aufgabe der Erfindung, ein Verfahren der eingangs bezeichneten Art zu schaffen, bei dem mit höheren mittleren Arbeitstemperaturen, als dies bei den bekannten Verfahren möglich ist, gearbeitet werden kann und bei dem dennoch eine homogene Bestrahlung der Fläche erzielt wird, ohne daß dabei die Gefahr des Auftretens von Temperaturspitzen besteht. Die Aufgabe der Erfindung besteht ferner darin, eine zur Durchführung des Verfahrens geeignete Vorrichtung zu schaffen.

Diese Aufgabe wird gemäß der Erfindung bei einem Verfahren der eingangs bezeichneten Art durch die im Anspruch 1 genannten Maßnahmen gelöst.

Die wesentlichen Verfahrensmaßnahmen gemäß der Erfindung bestehen dabei darin, daß die äußeren Ionen des Strahls durch seitliche Reflexion nach innen gerichtet werden, woraus eine Homogenisierung des Strahls und damit eine gleichmäßigere Bestrahlung der Fläche resultiert. Das dabei als Reflektor verwendete Linsensystem ist ein hochgradig nichtlineares Abbildungselement. Denn das den Strahl beeinflussende elektrische Feld ist maximal am Linsenrand, klingt exponentiell mit einer 1/e-Länge von $\lambda/(2\pi)$ ab - wobei $\lambda$ die Periodenlänge des Reflektors (Zwei-Elektrodenabstand) ist - und wird verschwindend klein für achsennahe Strahlen. Demzufolge werden die Ionen in einer dünnen Randschicht abgelenkt - sie werden reflektiert -, im ganzen übrigen Bereich dagegen nicht.

Für die Reflexion der Ionen am Reflektor gibt es einen Maximalwinkel $\alpha_{max}$, für den Ionen noch reflektiert werden. Er bestimmt sich aus dem Verhältnis des alternierenden Potentials zum Ionenquellenpotential.

Eine Weiterausgestaltung des Verfahrens gemäß der Erfindung besteht daher darin, daß die Ionen darart fokussiert werden, daß die Winkel zwischen den Ionenbahnen und der Längsrichtung des Reflektors den Maximalwinkel

$$\alpha_{max} = g\ \frac{1}{2}\ \frac{\Delta V}{U}$$

nicht überschreiten, wobei
$g \leq 0.7$

$\pm \Delta V$:     an den Elektroden anliegendes elektrisches Potential [Volt]

U:     die elektrische Spannung [Volt] , mit der die kinetische Energie eU der Ionen angegeben wird (e: Elementarladung).

Dadurch, daß die rotierende, zu bestrahlende Fläche rotationssymmetrisch zur Längsachse des Strahltransportsystems angeordnet ist, ist lediglich die Stromdichte des Strahls in radialer Richtung zu verändern, um eine noch homogenere Bestrahlungsdosis zu erhalten. Die radiale Stromverteilungsdichte kann dabei - bei unverändertem Reflektor - über die Fokussierungsstärke verändert werden. Bei starker Aufweitung des Strahls werden relativ große Anteile des Strahls reflektiert, bei geringer Aufweitung ist dagegen der reflektierte Anteil klein.

Wenngleich somit schon durch die Aufweitung des Ionenstrahls in Verbindung mit einer entsprechenden Einstellung der Fokussierung und Reflexion der äußeren Ionen eine weitgehend homogene Bestrahlung der Fläche ohne Bildung von Temperaturspitzen erzielt wird, kann doch durch entsprechende Regelung eine noch gleichmäßigere Bestrahlung der Fläche erzielt werden. Dies geschieht dadurch, daß die Stärke der Fokussierung zeitlich variiert wird, wobei jeweils diejenige Stärke der Fokussierung eingestellt wird, die den Unterschied zwischen der bereits applizierten und der gewünschten gleichmäßigen Bestrahlungsdosis nach Maßgabe von Eichwerten möglichst weitgehend vermindert.

Die Fokussierungsstärke wird dabei in einem festen Zeittakt verändert, wobei der Zeittakt kurz (z. B. eine Sekunde) gegen die insgesamt vorgesehene Bestrahlungszeit ist.

Zu Beginn der Bestrahlung werden für verschiedene Fokussierungsstärken $F_1$, $F_2$, ..., $F_n$ Stromverteilungen gemessen und gespeichert. Danach wird aus den gemessenen Stromverteilungen diejenige rechnerisch ermittelt, die die Diskrepanz zwischen bereits applizierter Dosis und angestrebter Dosis am nachhaltigsten zu vermindern vermag. Sie wird für den nächsten Zeittakt (die nächste Sekunde) eingestellt, und mit den während der Bestrahlung gemessenen Stromwerten wird die abgespeicherte Stromdichteverteilung aktualisiert. Während der kontinuierlich weitererfolgenden Bestrahlung ermittelt der Rechner der Regeleinrichtung bereits die nächste Einstellung.

Das Verfahren gemäß der Erfindung kann überall dort eingesetzt werden, wo großflächige Ionenbestrahlungen angestrebt werden, so beispielsweise bei der Ionenimplantation, aber auch beim Ionenmischen und beim reaktiven Ionenstrahlätzen.

Außer der Vermeidung von Temperaturspitzen auf den zu bestrahlenden Flächen sowie der Möglichkeit, die mittlere Arbeitstemperatur heraufzusetzen, ist beim Verfahren gemäß der Erfindung noch von Vorteil, daß keine schnell veränderlichen elektrischen und magnetischen Felder verwendet werden. Dadurch sind die Verhältnisse der Raumladungskompensation zeitlich konstant, wodurch Strahlinstablilitäten vermieden werden. Außerdem ist von Vorteil, daß das Verfahren ohne Einschränkung in Hoch- und Höchststromanlagen eingesetzt werden kann.

Zur Durchführung des Verfahrens gemäß der Erfindung dient eine Vorrichtung mit den in Anspruch 5 genannten Merkmalen. Dabei dient die entsprechend ausgelegte Linse zur Einstellung des die insgesamt zu bestrahlende Fläche erfassenden Strahls und der Reflektor zu dessen Vergleichmäßigung, um eine möglichst homogene Bestrahlung der Fläche zu erzielen.

Der Reflektor kann dabei unterschiedlich ausgestaltet sein. So sind die Elektroden des Ionenreflektors bei einer Ausführungsart der Vorrichtung als Ringe ausgebildet, bei einer anderen Ausführungsart weisen die Elektroden des Ionenleiters die Form eines rechteckigen Rahmens auf, bei einer weiteren Ausführungsart sind die Elektroden des Ionenreflektors in Form einer mehrgängigen Schraube, beispielsweise in der Form einer Doppelhelix, ausgebildet.

Zur Durchführung der Verfahrensweise, bei der zur Erzielung einer gleichmäßigen Bestrahlung der Fläche die Stärke der Fokussierung zeitlich variiert wird, ist eine Vorrichtung geeignet, bei der eine Regeleinrichtung vorgesehen ist, die eine Variation der Fokussierungsstärke bewirkt, wobei in vorbestimmtem Zeittakt diejenige Fokussierungsstärke eingestellt wird, die den Unterschied zwischen der jeweils bereits applizierten und der angestrebten, gleichmäßigen Bestrahlung der Fläche nach Maßgabe von Eichwerten möglichst weitgehend vermindert.

Als äquivalente Ausführungsart zu der beschriebenen Vorrichtung ist eine Vorrichtung anzusehen, bei der die Strahlführung mittels des Reflektors nicht elektrostatisch, sondern magnetisch ausgelegt ist.

Eine Ausführungsform der Vorrichtung ist in der Zeichnung schematisch dargestellt.

Es zeigen

Figur 1     einen Längsschnitt durch einen Teil einer Vorrichtung zur Implantation von Ionen in ein Target,

Figur 2     einen Querschnitt durch die Vorrichtung gemäß Figur 1 längs der Linie A/A'

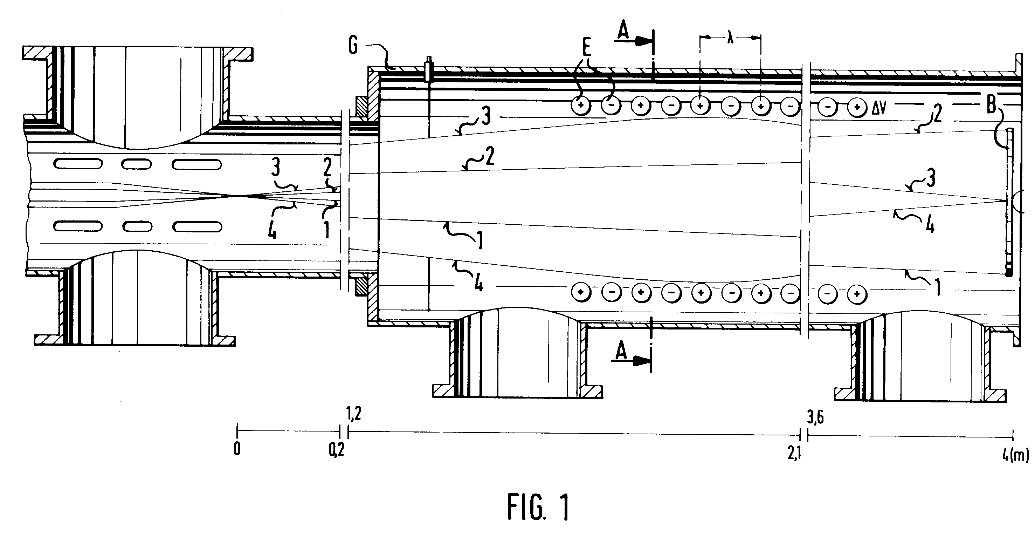

Dem in Figur 1 dargestellten Teil der Vorrichtung sind (in der Zeichnung nicht dargestellt) eine Ionenquelle, ein der Ionenquelle nachgeschaltetes Extraktionssystem zur Vorbeschleunigung der Ionen, ein magnetischer Dipol zur Trennung der Ionen nach Ionenmassen und eine Einrichtung zur Nachbeschleunigung der Ionen vorgeschaltet. Dargestellt ist in Figur 1 eine Einzellinse zur Fokussierung des Ionenstrahls, eine der Einzellinse nachgeschaltete Blende, ein Ionenreflektor und das zu bestrahlende Target (Fläche B). Diese Elemente befinden sich in einem Gehäuse G, das an ein in der Zeichnung ebenfalls nicht dargestelltes Pumpsystem angeschlossen ist.

Der Abstand zwischen Einzellinse und Implantationsscheibe (Target; Fläche B) bestimmt sich aus dem Durchmesser der Implantationsscheibe und den zulässigen Divergenzwinkeln der Ionenstrahlen. Bei der in Figur 1 dargestellten Vorrichtung beträgt der Abstand zwischen Einzellinse und Scheibe 4 m, der Scheibendurchmesser 300 mm und der Dispersionswinkel ± 3°.

Wie aus Figur 1 zu entnehmen ist, werden die einzelnen, äußeren Ionenstrahlen 3 und 4 am Ionenreflektor so reflektiert, daß sie nach innen auf die rotierende Fläche B gerichtet werden. Dadurch wird der gesamte Ionenstrahl und damit auch die Bestrahlung des Targets (Fläche B) vergleichmäßigt. Durch Änderung der Fokussierungsstärke der Einzellinse im Verlauf einer Bestrahlung kann die Vergleichmäßigung der Bestrahlung noch verstärkt werden.

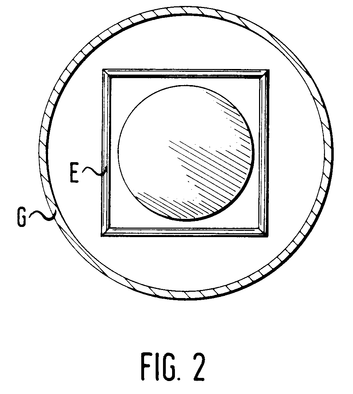

Aus Figur 2 ist zu entnehmen, daß der Ionenreflektor die Form eines rechteckigen Rahmens aufweist.

## Patentansprüche

1. Verfahren zur Bestrahlung großer Flächen mit Ionen, bei dem die aus einer Ionenquelle austretenden Ionen mittels eines nachgeschalteten Extraktionssystems beschleunigt, mittels eines magnetischen Dipols nach Ionenmassen getrennt, in einer nachgeschalteten Einrichtung nachbeschleunigt werden und der Ionenstrahl sodann fokussiert und auf die um die Mittelachse der Beschleunigungseinrichtungen rotierende, zu bestrahlende Fläche gerichtet wird, und bei dem der Ionenstrahl durch Fokussierung derart aufgeweitet wird, daß die zu bestrahlende Fläche von den hinter dem Fokus auseinanderlaufenden Ionen ganz erfaßt wird, **dadurch gekennzeichnet,** daß die Ionen (3, 4) des Randbereiches des aufgeweiteten Ionenstrahls durch einen den Strahl seitlich umfassenden Ionenreflektor reflektiert werden, wobei als Ionenreflektor länglich ausgebildete Elektroden (E) verwendet werden, die mit möglichst geringem Abstand mit ihrer Längsseite parallel zueinander, aufeinanderfolgend in Ebenen parallel zur mittleren Richtung des Ionenstrahls angeordnet sind und von denen jeweils benachbarte an ein elektrisches Potential entgegengesetzten Vorzeichens angelegt sind.

2. Verfahren nach Anspruch 1, **dadurch gekennzeichnet,** daß die Ionen (1, 2, 3, 4) derart fokussiert werden, daß die Winkel zwischen den Ionenbahnen und der Längsrichtung des Reflektors den Maximalwinkel

$$\varkappa_{max} = g \, \frac{1}{2} \, \frac{\Delta V}{U}$$

nicht überschreiten, wobei

$g \leq 0.7$

± V: an den Elektroden anliegendes elektrisches Potential

U: die elektrische Spannung [Volt], mit der die kinetische Energie eU der Ionen angegeben wird (e: Elementarladung).

3. Verfahren nach einem der Ansprüche 1 oder 2, **dadurch gekennzeichnet,** daß zur Erzielung einer gleichmäßigen Bestrahlung der Fläche (B) die Stärke der Fokussierung ($F_1$, $F_2$,..., $F_n$) zeitlich variiert wird, wobei jeweils diejenige Stärke der Fokussierung eingestellt wird, die den Unterschied zwischen der bereits applizierten und der gewünschten gleichmäßigen Bestrahlungsdosis nach Maßgabe von Eichwerten möglichst weitgehend vermindert.

4. Verfahren nach Anspruch 3, **dadurch gekennzeichnet,** daß die Fokussierungsstärke ($F_1$, $F_2$,..., $F_{n)}$ in einem festen Zeittakt verändert wird, wobei der Zeittakt kurz gegen die insgesamt vorgesehene Bestrahlungszeit ist.

5. Vorrichtung zur Durchführung des Verfahrens nach einem der Ansprüche 1 bis 4, die zur Bestrahlung großer Flächen mit Ionen vorgesehen ist und bei der ein der Ionenquelle nachgeschaltetes Extraktionssystem zur Vorbeschleunigung der Ionen, ein magnetischer Dipol zur Trennung der Ionen nach Ionenmassen, eine Einrichtung zur Nachbeschleunigung der Ionen, eine elektrostatische oder magnetische Linse zur Fokussierung des Ionenstrahls vorgesehen sind und bei der die Linse so ausgelegt ist, daß sie durch entsprechende Fokussierung eine derartige Aufweitung des Ionenstrahls ermöglicht, daß die zu bestrahlende Fläche (B) vom aufgeweiteten Ionenstrahl (1, 2, 3, 4) ganz erfaßt wird, **dadurch gekennzeichnet,** daß der Linse ein den Bereich des Ionenstrahls seitlich umfassenden Ionenreflektor nachgeschaltet ist, der aus länglich ausgebildeten, mit möglichst geringem Abstand mit ihrer Längsseite parallel zueinander, in Ebenen parallel zur mittleren Richtung des Ionenstrahls angeordneten Elektroden (E) besteht, von denen jeweils benachbarte an ein elektrisches Potential unterschiedlichen Vorzeichens angelegt sind und daß die zu bestrahlende Fläche (B) senkrecht zur Mittelachse der Beschleunigungseinrichtungen ausgerichtet und um die Mittelachse rotierbar ist.

**6.** Vorrichtung nach Anspruch 5,
**dadurch gekennzeichnet,**
daß die Elektroden (E) des Ionenreflektors als Ringe ausgebildet sind.

**7.** Vorrichtung nach Anspruch 5,
**dadurch gekennzeichnet,**
daß die Elektroden (E) des Ionenleiters die Form eines rechteckigen Rahmens aufweisen.

**8.** Vorrichtung nach Anspruch 5,
**dadurch gekennzeichnet,**
daß die Elektroden (E) des Ionenreflektors in Form einer mehrgängigen Schraube, beispielsweise in der Form einer Doppelhelix, ausgebildet sind.

**9.** Vorrichtung nach einem der Ansprüche 5 bis 8,
**dadurch gekennzeichnet,**
daß eine Regeleinrichtung vorgesehen ist, die zur Erzielung einer gleichmäßigen Bestrahlung der Fläche (B) eine Variation der Fokussierungsstärke ($F_1$, $F_2$,..., $F_n$) bewirkt, wobei in vorbestimmtem Zeittakt diejenige Fokussierungsstärke eingestellt wird, die den Unterschied zwischen der jeweils bereits applizierten und der angestrebten, gleichmäßigen Bestrahlung der Fläche (B) nach Maßgabe von Eichwerten möglichst weitgehend vermindert.

## Claims

**1.** Method of irradiating large surfaces with ions, wherein the ions issuing from an ion source are accelerated by means of a downstream extraction system, separated by means of a magnetic dipole according to ion masses, post-accelerated in a downstream device, and the ion beam is then focussed and directed on to the surface which is to be irradiated and which rotates about the central axis of the acceleration devices, and wherein the ion beam is so widened out by focussing that the surface being irradiated is wholly comprehended by the ions travelling away from one another after the focus, characterised in that the ions (3, 4) of the marginal region of the widened ion beam are reflected by an ion reflector surrounding the beam laterally, electrodes (E) of elongated construction being used as ion reflector which are arranged at the smallest possible spacing with their longitudinal side parallel to one another, in succession to one another in planes parallel to the mean direction of the ion beam, and whereof neighbouring electrodes in each case are connected to an electrical potential of opposite sign respectively.

**2.** Method according to claim 1, characterised in that the ions (1, 2, 3, 4) are so focussed that the angles between the ion paths and the longitudinal direction of the reflector do not exceed the maximum angle

$$\alpha_{max} = g \frac{1}{2} \frac{\triangle V}{U}$$

wherein
$g \leq 0.7$
$\pm V$ : electrical potential present at the electrode,
$U$ : the electrical voltage (volts) with which the kinetic energy eU of the ions is given (e : elementary charge).

**3.** Method according to one of claims 1 or 2, characterised in that the intensity of focussing ($F_1$, $F_2$..., $F_n$) is varied in time-variable manner, for achieving uniform irradiation of the surface (B), that focussing intensity being in each case adjusted which reduces as substantially as possible the difference between the already applied irradiation dose and the desired uniform irradiation dose, according to calibration values.

**4.** Method according to claim 3, characterised in that the focussing intensity ($F_1$, $F_2$, ... , $F_n$) is modified in a fixed time cycle, the time cycle being short relatively to the entire irradiation time provided.

**5.** Apparatus for carrying out the method according to one of claims 1 to 4, which is provided for irradiation of large surfaces with ions and wherein there are provided an extraction system, downstream of the ion source, for the preliminary acceleration of the ions, a magnetic dipole for separating the ions according to ion masses, a device for the post-acceleration of the ions, an electrostatic or magnetic lens for focussing the ion beam, and wherein the lens is so designed that it allows, by suitable focussing, such a widening of the ion beam that the surface (B) being irradiated is completely comprehended by the widened ion beam (1, 2, 3, 4), characterised in that there is situated downstream of the lens an ion reflector which laterally surrounds the region of the ion beam and which consists of electrodes (E) arranged with as small a spacing as possible with their longitudinal sides parallel to one another, in planes parallel to the mean direction of the ion beam, respective neighbouring electrodes of said electrodes being connected to an electrical potential of different sign each, and that the surface (B) to be irradiated is directed perpendicularly to the central axis of the accelerating devices and is rotatable about the central axis.

6. Apparatus according to claim 5, characterised in that the electrodes (E) of the ion reflector are constructed as rings.

7. Apparatus according to claim 5, characterised in that the electrodes (E) of the ion conductor are in the form of a rectangular frame.

8. Apparatus according to claim 5, characterised in that the electrodes (E) of the ion reflector are constructed in the form of a multi-thread screw, for example in the form of a double helix.

9. Apparatus according to one of claims 5 to 8, characterised in that a control unit is provided which, for achieving a uniform irradiation of the surface (B), effects a variation of the focussing intensity ($F_1$, $F_2$, ..., $F_n$), adjustment being effected in a predetermined time cycle of that focussing intensity which reduces as substantially as possible the difference between the respective already applied and the desired uniform irradiation of the surface (B), in accordance with calibration values.

**Revendications**

1. Procédé d'exposition de grandes surfaces à des ions, qui consiste à accélérer les ions issus d'une source d'ions au moyen d'un système d'extraction en aval, à les séparer en fonction de la masse des ions au moyen d'un dipôle magnétique, à les post-accélérer dans un dispositif en aval et à focaliser immédiatement le faisceau d'ions et à le diriger sur la surface à exposer, qui tourne par rapport à l'axe médian des dispositifs d'accélération, le faisceau d'ions étant élargi par focalisation de façon que toute la surface à exposer soit couverte par les ions divergeant derrière le foyer, caractérisé, en ce qu'il consiste à réfléchir les ions (3, 4) de la partie marginale du faisceaux d'ions élargi, par un réflecteur d'ions entourant latéralement le faisceau en utilisant, comme réflecteur d'ions, des électrodes (E) oblongues qui se succèdent, à une distance aussi petite que possible et en étant parallèles entre elles par leurs grands côtés, dans des plans parallèles à la direction médiane du faisceau d'ions, des potentiels électriques de signe opposé étant appliqués à deux électrodes voisines.

2. Procédé suivant la revendication 1, caractérisé, en ce qu'il consiste à focaliser les ions (1, 2, 3, 4) de façon que l'angle entre les trajets des ions et la direction longitudinale du réflecteur ne dépasse Pas l'angle maximum

$$\chi_{max} = g\left(\frac{1}{2} - \frac{\Delta V}{U}\right)$$

formule dans laquelle
G ≤ 0,7
V est le potentiel électrique appliqué aux électrodes
U est la tension électrique [volt], avec laquelle est indiquée l'énergie cinétique eU des ions (e : charge élémentaire).

3. Procédé suivant l'une des revendications 1 ou 2, caractérisé, en ce qu'il consiste, pour obtenir une exposition uniforme de la surface (B), à faire varier dans le temps l'intensité de la focalisation ($F_1$, $F_2$, ..., $F_n$), en prenant pour intensité de la focalisation celle qui diminue dans la plus grande mesure possible la différence entre la dose d'exposition déjà appliquée et la dose d'exposition uniforme souhaitée, en fonction de valeurs d'étalonnage.

4. Procédé suivant la revendication 3, caractérisé, en ce qu'il consiste à modifier l'intensité de focalisation ($F_1$, $F_2$, ..., $F_n$) à une cadence fixe, la cadence étant courte par rapport à la durée d'exposition prévue dans son ensemble.

5. Installation pour la mise en oeuvre du procédé suivant l'une des revendications 1 à 4, qui est prévu pour l'exposition de grandes surfaces par des ions et dans laquelle un système d'extraction, en aval de la source d'ions, est destiné à la préaccélération des ions et dans laquelle il est prévu un système d'extraction en aval de la source d'ions, pour préaccélérer les ions, un dipôle magnétique pour séparer les ions suivant leur masse, un dispositif de post-accélération des ions, une lentille électrostatique ou magnétique pour focaliser le faisceau d'ions, la lentille étant telle qu'elle permet, par une focalisation convenable, un élargissement du faisceau d'ions tel que la surface (B) à exposer est entièrement couverte par le faisceau d'ions (1, 2, 3, 4) élargi,

caractérisée,

en ce que en aval de la lentille est montée un réflecteur d'ions entourant latéralement la partie du faisceau d'ions et constitué d'électrodes (E) oblongues et disposées à faible distance en étant parallèles entre elles par leurs grands côtés dans des plans parallèles à la direction médiane du faisceau d'ions, des potentiels électriques de signes différents étant appliqués à deux électrodes voisines, et en ce que la surface (B) à exposer est dirigée perpendiculairement à l'axe médian des dispositifs d'accélération et peut tourner par rapport à l'axe médian.

6.  Installation suivant la revendication 5,
    caractérisée,
    en ce que les électrodes (E) du réflecteur d'ions sont constituées d'anneaux.

7.  Installation suivant la revendication 5,
    caractérisée,
    en ce que les électrodes (E) du conducteur d'ions présentent la forme d'un cadre rectangulaire.

8.  Installation suivant la revendication 5,
    caractérisée,
    en ce que les électrodes (E) du réflecteur d'ions sont constituées sous la forme d'une vis à pas multiples, par exemple sous la forme d'une hélice double.

9.  Installation suivant l'une des revendications 5 à 8,
    caractérisée,
    en ce qu'il est prévu un dispositif de réglage qui, pour obtenir une exposition uniforme de la surface (B), provoque une variation de l'intensité de focalisation ($F_1$, $F_2$, ..., $F_n$) avec établissement à une cadence prescrite de l'intensité de focalisation qui diminue, dans la plus grande mesure possible, la différence entre l'exposition déjà appliquée et l'exposition uniforme visée de la surface (B), en fonction de valeurs d'étalonnage.

FIG. 1

EP 0 311 976 B1

FIG. 2